# EUROPÄISCHE PATENTANMELDUNG

(11) **EP 4 512 753 A1**
(43) Veröffentlichungstag der Anmeldung: **26.02.2025**
(21) Anmeldenummer: 24153331.4
(22) Anmeldetag: 23.01.2024
(51) Int. Cl.: B65G 47/14, B23P 19/00, H05K 1/00

(54) **VEREINZELUNGSANLAGE**

(30) Priorität: 23.01.2023 DE 102023101493
(71) Anmelder: Ginzinger, Herbert, 4943 Geinberg (AT); Wimmer, Johann, 5411 Handenberg (AT)
(72) Erfinder: Ginzinger, Herbert, 4943 Geinberg (AT); Wimmer, Johann, 5411 Handenberg (AT)
(74) Vertreter: Rothkopf, Ferdinand

(57) **Zusammenfassung**

Die Erfindung betrifft eine Vereinzelungsanlage (10) zum Vereinzeln von Bauelementen (36) aus einem Bauelementbehälter (34), mit einer Transporteinrichtung (12) zum Bewegen des Bauelementbehälters (34) und mindestens einer Entnehmereinrichtung (38) zum Entnehmen eines Bauelements aus dem Bauelementbehälter (34), wobei die Transporteinrichtung (12) mit mindestens einem Bauelementbehältertransporter (24) gestaltet ist, der mittels Statormotor (32) in einer X-Richtung und in einer Y-Richtung zu verfahren ist, und die Entnehmereinrichtung (38) mit mindestens einem Bauelemententnehmer (40) gestaltet ist, der zum Entnehmen eines Bauelements (36) auf dem Bauelementbehälter (34) in einer Z-Richtung zu verfahren ist.

## Beschreibung

Die Erfindung betrifft eine Vereinzelungsanlage bzw. einen Vereinzelungstisch zum Vereinzeln von Bauelementen bzw. Bauelementen, insbesondere elektrischen Bauelementen, aus einem Bauelementbehälter, wie insbesondere einer Schütte, mit einer Transporteinrichtung zum Bewegen des Bauelementbehälters und mindestens einer Entnehmereinrichtung zum Entnehmen eines Bauelements aus dem Bauelementbehälter.

Unter Bauelementen werden dabei alle Arten von Bauelementen und Bauteilen verstanden, so wie etwas Halbleiter, Kühlkörper, Ableitfedern, Verbindungselemente, Abstandselemente, Gewindebolzen, Stecker, aktive und passive Bauelemente (z.B. Widerstände oder Kondensatoren) mechanische Bauelemente (z.B. Kühlkörper) und elektromechanische Bauelemente (z.B. Schalter, Taster oder Relais).

Herkömmlicherweise weist eine Vereinzelungsanlage zum Vereinzeln von Bauelementen aus einem Bauelementbehälter - wobei sich die Bauelemente in dem Bauelementbehälter insbesondere in ungeordneter Lage befinden, wie etwa in einer Schütte oder in einem Becher - einen Rüttler sowie einen Vereinzler auf, mittels derer die Bauelemente aus dem Bauelementbehälter heraus zunächst zu einer Kette angeordnet werden. Am Ende der Kette wird dann ein Bauelement in eine definierte Abnahmeposition gebracht, von wo aus es entnommen und insbesondere für eine Entnehmereinrichtung bereit gestellt werden kann. Derartige Rüttler und Vereinzler sind vergleichsweise konstruktiv aufwändig gestaltet und daher teuer und fehleranfällig. Ferner werden mit Ihnen die Bauelemente vergleichsweise viel bewegt, was für diese schädlich sein kann.

Es ist ferner bekannt Bauelemente in einem Tray oder Blister an einer Entnehmereinrichtung bereit zu stellen, wobei die Bauelemente dann bereits in dem Tray oder Blister in einer geordneter Lage angeordnet sind. Für eine derartige Bereitstellung sind zwar dann keine Vereinzler erforderlich, doch müssen die Bauelemente mit vergleichsweise hohem Aufwand zuvor in den Tray oder Blister vereinzelt worden sein.

### Zugrundeliegende Aufgabe

Der Erfindung liegt die Aufgabe zugrunde, eine Vereinzelungsanlage zu schaffen, die technologisch besonders einfach aufgebaut und zu betreiben ist und die zugleich eine sehr hohe Flexibilität bei den zu bewältigenden Vereinzelungsungsvorhaben aufweist.

### Erfindungsgemäße Lösung

Diese Aufgabe ist erfindungsgemäß mit einer Vereinzelungsanlage zum Vereinzeln von Bauelementen aus einem Bauelementbehälter gelöst, mit einer Transporteinrichtung zum Bewegen des Bauelementbehälters und mindestens einer Entnehmereinrichtung zum Entnehmen eines Bauelements aus dem Bauelementbehälter, wobei die Transporteinrichtung mit mindestens einem Bauelementbehältertransporter gestaltet ist, der mittels Statormotor bzw. Planarmotor in einer X-Richtung und in einer Y-Richtung zu verfahren ist, und die Entnehmereinrichtung mit mindestens einem Bauelemententnehmer gestaltet ist, der zum Entnehmen eines Bauelements aus dem Bauelementbehälter allein in einer Z-Richtung zu verfahren ist.

Erfindungsgemäß ist zum Transport von Bauelementbehältern innerhalb einer Vereinzelungsanlage ein Planarmotor-Positioniersystem bzw. Statormotor-Positioniersystem vorgesehen. Bei einem solchen Positioniersystem ist ein Positionierschlitten als Bauelementbehältertransporter unter Ausführung einer Positionierbewegung in einer durch ein kartesisches X-Y-Koordinatensystem definierten Positionierebene relativ zu einem Transportertisch bzw. Schlittenträger und einem dort ortsfest angeordneten Bauelemententnehmer variabel verfahrbar und positionierbar.

Das erfindungsgemäße Statormotor-Positioniersystem umfasst vorzugsweise eine am Schlittenträger angeordnete Statoranordnung, die einen X-Statorabschnitt bzw. eine X-Antriebsspule und einen Y-Statorabschnitt bzw. eine Y-Antriebsspule aufweist. Die Antriebsspulen bilden also einen Stator des Schlittenträgers. Der X-Statorabschnitt dient dazu, ein in der X-Richtung bewegbares, magnetisches Wanderfeld bereitzustellen, während der Y-Statorabschnitt dazu dient, ein in der Y-Richtung bewegbares, magnetisches Wanderfeld bereitzustellen.

Der Positionierschlitten verfügt über eine Magnetanordnung, insbesondere in Form von Permanent- und/oder Elektromagneten, die während der Positionierbewegung gleichzeitig mit dem X-Wanderfeld und dem Y-Wanderfeld in magnetischer Wechselwirkung steht. Der Positionierschlitten ist durch Bewegung des X-Wanderfelds zu einer Positionierbewegung in der X-Richtung des X-Y-Koordinatensystems und durch Bewegung des Y-Wanderfelds zu einer Positionierbewegung in der Y-Richtung des X-Y-Koordinatensystems antreibbar.

Der Statormotor bildet also insbesondere eine Förderstrecke in X-Richtung und in Y-Richtung aus, entlang der einzelne Bauelementbehältertransporter bewegt werden können. Die Bauelementbehältertransporter werden dabei vorteilhaft an der Förderstrecke gehalten und geführt.

Durch gezieltes Ansteuern des derartigen Statormotor-Positioniersystems kann so ein Bauelementbehältertransporter mit seinem darauf angebrachten Bauelementbehälter an einer Entnehmereinrichtung in X-Richtung und in Y-Richtung derart verfahren werden, dass ein bestimmtes Bauelement im Bauelementbehälter in eine vordefinierte Lage relativ zur Entnehmereinrichtung gebracht wird. Die Entnehmereinrichtung muss dann zum Entnehmen dieses Bauelements aus dem Bauelementbehälter nurmehr in einer Z-Richtung bewegt bzw. verfahren werden.

Damit können erfindungsgemäß die Bewegungsabläufe hinsichtlich der Bewegung des Bauelementbehälters in X-Richtung und Y-Richtung besonders flexibel gestaltet und zugleich kann die Bewegung der Entnehmereinrichtung in Z-Richtung konstruktiv besonders einfach realisiert werden. Insbesondere ist dabei die
Entnehmereinrichtung allein in Z-Richtung zu verfahren. Ferner können mit der derartigen Vorgehensweise vorteilhaft nicht nur gleichartige Bauelemente, sondern auch verschiedenartige, insbesondere verschieden geformte Bauelemente aus nur einem Bauelementbehälter entnommen werden. Die erfindungsgemäße Entnehmereinrichtung weist dabei vorzugsweise einen Bauelementgreifer auf, der insbesondere derart gestaltet ist, dass er auch Bauelemente mit verschiedenen Bauelementbreiten ergreifen kann.

Bei einer vorteilhaften Weiterbildung der Erfindung ist ein Bauelementspeicher vorgesehen und der Bauelemententnehmer ist zum Ablegen des entnommenen Bauelements an dem Bauelementspeicher angepasst. Vom Bauelemententnehmer sind die entnommenen Bauelemente also an dem Bauelementspeicher insbesondere zumindest kurzzeitig zwischenzuspeichern. Der Bauelementspeicher kann damit auch als Manipulierhilfe und auch zum Umgreifen des Bauelemententnehmers genutzt werden.

Ferner ist an der erfindungsgemäßen Vereinzelungsanlage direkt oder an einer zugehörigen Entnehmereinrichtung zumindest ein Werkstück angeordnet und der Bauelemententnehmer ist zum Platzieren des entnommenen Bauelements direkt oder indirekt an dem Werkstück angepasst.

Dabei ist vorzugsweise ein Werkstücktransporter zum Transportieren des Werkstücks vorgesehen, der mittels des Statormotors in der X-Richtung und in der Y-Richtung zu verfahren ist. Darüber hinaus ist der Werkstücktransporter vorteilhaft mittels des Statormotors um die Z-Richtung zu drehen.

Auch der Bauelementbehältertransporter der erfindungsgemäßen Vereinzelungsanlage ist vorteilhaft mittels des Statormotors um die Z-Richtung zu drehen, so dass damit die Z-Drehlage des jeweiligen, aufzunehmenden Bauelements relativ zum Bauelemententnehmer angepasst werden kann. Alternativ kann diese Rotation um die Z-Richtung auch von dem Bauelemententnehmer, insbesondere mittels eines Drehkopfes übernommen werden.

Der mindestens eine Bauelementbehältertransporter ist erfindungsgemäß bevorzugt mittels Statormotor bezogen auf die X-Y-Ebene zu kippen. Mit dem Kippen können Bauelemente im Bauelementbehälter zusätzlich in eine andere Lage relativ zum Bauelemententnehmer gebracht werden. Ferner ist das Kippen vorteilhaft, wenn, wie nachfolgend noch erläutert wird, weitere Bearbeitungsfunktionen mit in die erfindungsgemäße Vereinzelungsanlage integriert werden, wie insbesondere ein Vergießen von Bauelementen oder auch ein Verschrauben.

Auch ist es gemäß der Erfindung bevorzugt, dass der mindestens eine Bauelementbehältertransporter mittels Statormotor auf einer Unterlage, insbesondere auf dem Transportertisch bzw. Schlittenträger, abzulegen ist. Mit dem derartigen Ablegen kann eine besonders lagegenaue und auch stabile Positionierung eines auf dem Bauelementbehältertransporter befindlichen Bauelementbehälters erreicht werden.

Der mindestens eine Bauelementbehältertransporter ist ferner bevorzugt mittels Statormotor zu wiegen. Mittels einer solchen Wiegefunktion können zum einen Überwachungs- und Prüffunktionen realisiert oder auch Bearbeitungsfunktionen, wie etwas das Auf- bzw. Eingießen einer Vergussmasse, gesteuert werden.

Darüber hinaus ist die erfindungsgemäße Entnehmereinrichtung vorzugsweise zugleich als mindestens eine Entnehmereinrichtung zum Durchführen mindestens eines weiteren Bearbeitungsschritts an dem aus dem Bauelementbehälter entnommenen Bauelement gestaltet - insbesondere in Gestalt einer Formänderungseinrichtung, einer Montageeinrichtung und/oder einer Messeinrichtung. Mittels einer derartigen Doppelfunktion der erfindungsgemäßen Vereinzelungsanlage zur Vereinzelung und zugleich zur Bearbeitung von Bauelementen kann das erfindungsgemäße Prinzip des Bewegens eines Transporters mittels Statormotor gewinnbringend auch für andere Bearbeitungsfunktionen und insbesondere auch für eine umfassendere oder umfangreichere Montagefunktionalität direkt an der Vereinzelungsanlage genutzt werden.

Ferner ist an dem mindestens einen Bauelemententnehmer vorteilhaft eine Reinraumhaube zum Überdecken des Bauelemententnehmers samt eines dorthin gefahrenen Bauelementbehältertransporters vorgesehen. Mittels der Reinraumhaube kann ein abgeschlossener oder zumindest weitgehend abgeschlossener Raum geschaffen werden, in dem insbesondere für eine Bauelementmontage die erforderlichen Umgebungsbedingungen geschaffen werden können, wie insbesondere eine geringe Teilchenbelastung in der Raum luft.

Schließlich ist an der erfindungsgemäßen Vereinzelungsanlage vorzugsweise eine Steuereinrichtung zum aufeinander abgestimmten Steuern von Verfahrwegen von Bauelementbehältertransportern und Bauelemententnehmern sowie vorzugsweise auch Bearbeitungsfunktionen, insbesondere mittels künstlicher Intelligenz, vorgesehen.

Zum Erkennen der Lage von Bauelementen in dem Bauelementbehälter gemäß der Erfindung ist vorzugsweise an der erfindungsgemäßen Vereinzelungsanlage eine Bilderkennungseinrichtung zum Erkennen der Lage von mindestens einem Bauelement in dem Bauelementbehälter vorgesehen. Mittels der von der Bilderkennungseinrichtung ermittelten X- sowie Y-Positionslage und Z-Drehlage des jeweiligen Bauelements kann dann von dem Bauelementbehältertransporter die entsprechende Position angefahren und das jeweilige Bauelement so unter dem Bauelemententnehmer lagerichtig positioniert werden.

Schließlich ist bei der erfindungsgemäßen Vereinzelungsanlage vorteilhaft eine Manipulationseinrichtung zum Verändern der Lage von mindestens einem Bauelement in dem Bauelementbehälter vorgesehen ist. Eine solche Manipulationseinrichtung ist insbesondere in Gestalt eines in den Bauelementbehälter eingreifenden, bewegbaren Arms oder auch mittels einer Schütteleinrichtung für den Bauelementbehälter gestaltet. Die zugehörige Schüttelbewegung kann dabei auch mittels des Transporters vom Statormotor erzeugt sein. Mittels der derartigen Manipulationseinrichtung kann die Lage von Bauelementen im Bauelementbehälter derart verändert werden, dass der Bauelemententnehmer mindestens ein Bauelement in vorteilhafter Weise dort entnehmen kann.

### Kurzbeschreibung der Zeichnungen

Nachfolgend wird ein Ausführungsbeispiel einer erfindungsgemäßen Lösung anhand der beigefügten schematischen Zeichnungen näher erläutert. Es zeigt:
- Fig. 1: eine Draufsicht auf ein Ausführungsbeispiel einer erfindungsgemäßen Vereinzelungsanlage,
- Fig. 2: die Vorderansicht der Vereinzelungsanlage gemäß Fig. 1,
- Fig. 3: eine Draufsicht auf einen Bauelementbehälter 34 bei einer ersten Position des Bauelementbehältertransporters 24,
- Fig. 4: die Ansicht gemäß Fig. 3 bei einer zweiten Position des Bauelementbehältertransporters 24 und
- Fig. 5: die Ansicht gemäß Fig. 4 bei einer dritten Position des Bauelementbehältertransporters 24.

### Detaillierte Beschreibung des Ausführungsbeispiels

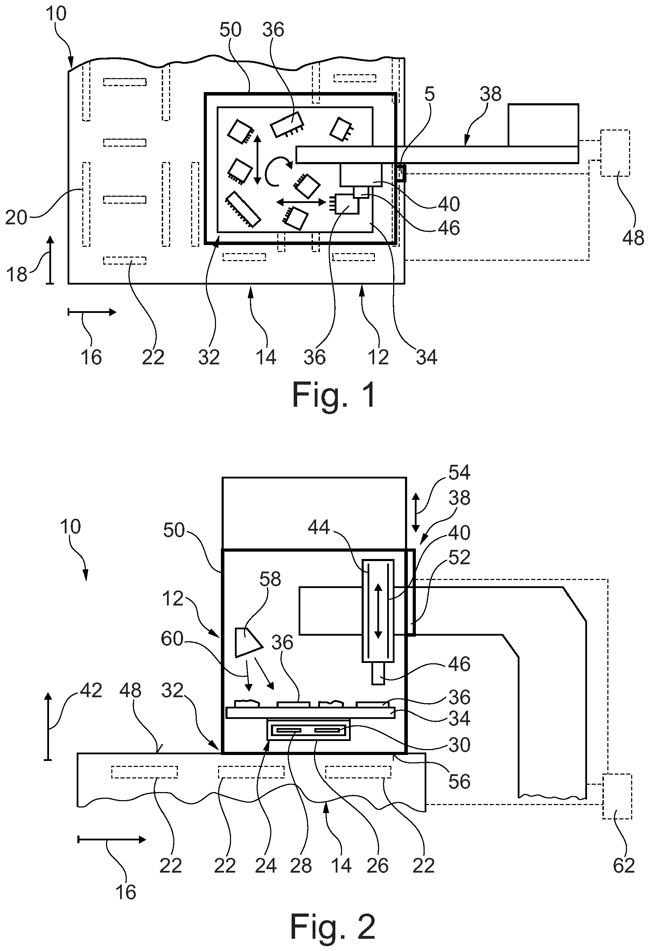

In den Fig. 1 und 2 ist eine Vereinzelungsanlage 10 dargestellt, die ein Positioniersystem bzw. eine Transporteinrichtung 12 mit einem Schlittenträger bzw. Transportertisch 14 umfasst. Der Transportertisch 14 erstreckt sich mit einer ebenen Oberfläche in eine X-Richtung 16 sowie eine Y-Richtung 18. Unter der Oberfläche des Transportertisches 14 sind in geordneter, regelmäßiger Anordnung mehrere X-Antriebsspulen 20 sowie Y-Antriebsspulen 22 angeordnet, mittels denen mit Hilfe von elektrischem Strom elektromagnetische X-Wanderfelder und Y-Wanderfelder erzeugt werden können.

Die Oberfläche des Transportertisches 14 dient dabei als Unterlage bzw. Schlittenträger für mindestens einen Positionierschlitten bzw. Bauelementbehältertransporter 24, in dem sich zumindest ein X-Elektromagnet 28 und zumindest ein Y-Elektromagnet 30 befinden. Diese Elektromagnete wirken mit den oben genannten Wanderfeldern in der Funktionsweise eines Statormotors 32 zusammen, wodurch der Bauelementbehältertransporter 24 auf dem Transportertisch 14 weitestgehend frei in X-Richtung 16 sowie in Y-Richtung 18 beweglich und insbesondere auch drehbar, kippbar sowie zu vibrieren ist.

Auf dem Bauelementbehältertransporter 24 ist ein Bauelementbehälter 34 abgelegt, gegebenenfalls geklemmt und auf diese Weise dort ortsfest gehalten. In dem Bauelementbehälter 34 befindet sich eine Vielzahl an Bauelementen 36 von vorliegend unterschiedlicher Art. Diese Bauelemente 36 können aus dem Bauelementbehälter 34 mittels einer ortsfest neben dem Transportertisch 14 angeordneten Entnehmereinrichtung 38 einzeln entnommen bzw. vereinzelt werden.

Dazu weist die Entnehmereinrichtung 38 mindestens einen Bauelemententnehmer 40 auf, der allein in einer Z-Richtung 42 mittels einer Z-Achsschiene 44 verfahrbar ist. An dem Bauelemententnehmer 40 befindet sich ein Entnehmerkopf 46, insbesondere in Form eines Greifers, mittels dem je ein Bauelement 36 aus dem Bauelementbehälter 34 heraus genommen wird.

Der Transportertisch 14 weist oberseitig eine im Wesentlichen ebene Oberfläche 48 auf. An der Entnehmereinrichtung 38 ist ferner eine Reinraumhaube 50 angeordnet, die in Form einer nach unten hin offenen, quaderförmigen Hülle gestaltet, ist. Die Reinraumhaube 50 ist mittels einer Hebe-Senk-Vorrichtung 52 um einen Hebe-Senk-Weg 54 von ihrer in Fig. 2 dargestellten, abgesenkten Stellung nach vertikal oben hin anhebbar und danach nach vertikal unten hin absenkbar. Der Hebe-Senk-Weg 54 ist so groß gestaltet, dass in dem beim Anheben freien Bereich unter der Reinraumhaube 50 ein Bauelementt4ansporter 24 inklusive Bauelementbehälter 34 und Bauelement 36 verfahren kann. Im dargestellten, abgesenkten Zustand liegt die Reinraumhaube 50 mit ihrer unteren Randfläche bzw. Unterseite 56, die weitestgehend eben ist, auf der ebenfalls weitestgehend ebenen Oberfläche 48 des Transportertisches 14 auf und dichtet dort weitgehend gasdicht ab.

Im Inneren der Reinraumhaube 50 befindet sich ein Bilderkennungseinrichtung 58 mittels der unter Zuhilfenahme von Licht 60 die X- und Y-Position sowie die Z-Drehlage von mindestens einem Bauelement 36 in dem Bauelementbehälter 34 ermittelt werden kann.

Die dann erfolgenden Bewegungen des mindestens einen Bauelementbehältertransporters 24 in X-Richtung 16, Y-Richtung 18 sowie Rotation um die Z-Richtung 42 zum lagegenauen Anordnen des von der Bilderkennungseinrichtung 58 erkannten Bauelements 36 in dem Bauelementbehälter 34 unter dem mindestens einen Bauelemententnehmer 40 sowie das Bewegen des jeweils zugehörigen Entnehmerkopfes 46, wie auch das Anheben und Absenken der Reinraumhaube 50 mittels der Hebe-Senk-Vorrichtung 52 sowie das Ein- und Ausschalten der Bilderkennungseinrichtung 58 wird mittels einer Steuereinrichtung 62 gesteuert, deren Funktionalität mittels künstlicher Intelligenz kontinuierlich weiterentwickelt wird.

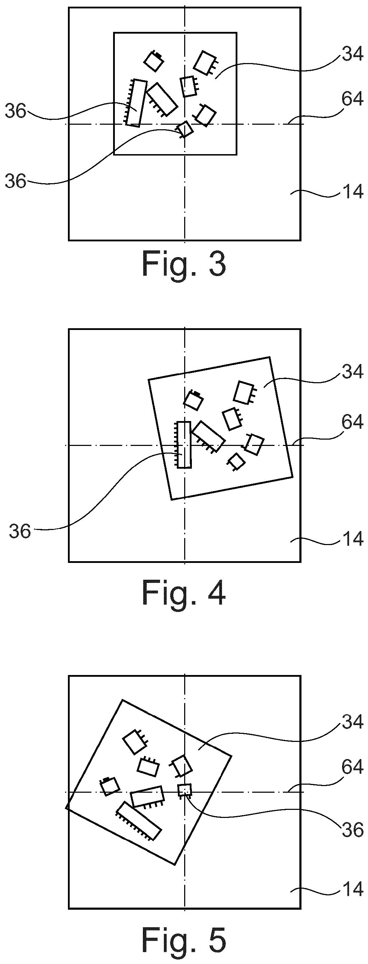

Die Fig. 3 bis 5 veranschaulichen, wie das Erkennen des jeweiligen Bauelements 36 mittels der Bilderkennungseinrichtung 58 und das lagerichtige Positionieren des Bauelementbehälters 34 unter der Entnehmereinrichtung 38 abläuft. Die Position der Entnehmereinrichtung 38 ist damit mittels eines Linien-Kreuzes 64 dargestellt. Gemäß Fig. 3 befindet sich der Bauelementbehälter 34 mit den darin liegenden Bauelementen 36 in einer ungedrehten X-Y-Position unter der Entnehmereinrichtung 38. In dieser Lage beginnt die Bilderkennungseinrichtung 58 zu arbeiten und ermittelt die X-Y-Lage sowie die Z-Drehlage von einem dieser Bauelemente 36. Diese Daten gibt die Bilderkennungseinrichtung 58 an die Steuereinrichtung 62, mittels der dann der Statormotor 32 den Bauelementbehältertransporter 24 an die gemäß Fig. 4 passende Stelle verfährt. An dieser Stelle kann der Bauelemententnehmer 40 dieses Bauelement 36 allein durch ein Verfahren und Greifen in Z-Richtung 42 aus dem Bauelementbehälter 34 entnehmen und damit vereinzeln. Die Fig. 5 zeigt schließlich, wie die Verfahr- und Drehposition des Bauelementbehältertransporter 24 zum Entnehmen von einem der anderen Bauelemente 36 ist.

Die derart aus dem Bauelementbehälter 34 entnommenen Bauelemente 36 können vorliegend direkt oder nach einem Umsetzen an einem an der Entnehmereinrichtung 38 angeordneten Bauelementspeicher (nicht dargestellt) auf einem Werkstück, beispielsweise einer Leiterplatte, platziert werden. Dazu kann das Werkstück insbesondere mittels eines hier nicht dargestellten weiteren Transporters ähnlich zum Bauelementbehältertransporter 24 auf dem Transportertisch 14 mittels des Statormotors 32 passend für die dabei als Bearbeitungseinrichtung wirkende Entnehmereinrichtung 38 positioniert werden.

Abschließend sei angemerkt, dass sämtlichen Merkmalen, die in den Anmeldungsunterlagen und insbesondere in den abhängigen Ansprüchen genannt sind, trotz des vorgenommenen formalen Rückbezugs auf einen oder mehrere bestimmte Ansprüche, auch einzeln oder in beliebiger Kombination eigenständiger Schutz zukommen soll.

### Bezugszeichenliste

- 10: Vereinzelungsanlage
- 12: Transporteinrichtung
- 14: Transportertisch
- 16: X-Richtung
- 18: Y-Richtung
- 20: X-Antriebsspule
- 22: Y-Antriebsspule
- 24: Bauelementbehältertransporter
- 26: Magnetanordnung
- 28: X-Elektromagnet
- 30: Y-Elektromagnet
- 32: Statormotor
- 34: Bauelementbehälter
- 36: Bauelement
- 38: Entnehmereinrichtung
- 40: Bauelemententnehmer
- 42: Z-Richtung
- 44: Z-Verfahrschiene
- 46: Entnehmerkopf
- 48: Oberfläche des Transportertisches
- 50: Reinraumhaube
- 52: Hebe-Senk-Vorrichtung
- 54: Hebe-Senk-Weg
- 56: Unterseite der Reinraumhaube
- 58: Bilderkennungseinrichtung
- 60: Licht
- 62: Steuereinrichtung
- 64: Linien-Kreuz

## Patentansprüche

1. Vereinzelungsanlage (10) zum Vereinzeln von Bauelementen (36) aus einem Bauelementbehälter (34), mit einer Transporteinrichtung (12) zum Bewegen des Bauelementbehälters (34) und mindestens einer Entnehmereinrichtung (38) zum Entnehmen eines Bauelements (36) aus dem Bauelementbehälter (34), **dadurch gekennzeichnet, dass** die Transporteinrichtung (12) mit mindestens einem Bauelementbehältertransporter (24) gestaltet ist, der mittels Statormotor (32) in einer X-Richtung (16) und in einer Y-Richtung (18) zu verfahren ist, und die Entnehmereinrichtung (38) mit mindestens einem Bauelemententnehmer (40) gestaltet ist, der zum Entnehmen eines Bauelements (36) aus dem Bauelementbehälter (34) in einer Z-Richtung (42) zu verfahren ist.
(gleiche oder verschiedene Bauelemente) (Bauelementgreifer am Bauelemententnehmer)

2. Vereinzelungsanlage nach Anspruch 1,
**dadurch gekennzeichnet, dass** der Bauelemententnehmer (40) zum Entnehmen eines Bauelements (36) aus dem Bauelementbehälter (34) allein in der Z-Richtung (42) zu verfahren ist.

3. Vereinzelungsanlage nach Anspruch 1 oder 2,
**dadurch gekennzeichnet, dass** ein Bauelementspeicher vorgesehen ist und der Bauelemententnehmer (40) zum Ablegen des entnommenen Bauelements (36) an dem Bauelementspeicher angepasst ist.

4. Vereinzelungsanlage nach einem der Ansprüche 1 bis 3,
**dadurch gekennzeichnet, dass** ein Werkstück vorgesehen ist und der Bauelemententnehmer (40) zum Platzieren des entnommenen Bauelements (36) an dem Werkstück angepasst ist.

5. Vereinzelungsanlage nach Anspruch 4,
**dadurch gekennzeichnet, dass** ein Werkstücktransporter zum Transportieren des Werkstücks auf dem Transportertisch 14 vorgesehen ist, der mittels des Statormotors (32) in der X-Richtung (16) und in der Y-Richtung (18) zu verfahren ist.

6. Vereinzelungsanlage nach Anspruch 5,
**dadurch gekennzeichnet, dass** der Werkstücktransporter mittels des Statormotors (32) um die Z-Richtung (42) zu drehen ist.

7. Vereinzelungsanlage nach einem der Ansprüche 1 bis 6,
**dadurch gekennzeichnet, dass** der Bauelementbehältertransporter (24) mittels des Statormotors (32) um die Z-Richtung (42) zu drehen ist.

8. Vereinzelungsanlage nach einem der Ansprüche 1 bis 7,
**dadurch gekennzeichnet, dass** der Bauelementbehältertransporter (24) mittels des Statormotors (32) zu kippen, auf einer Unterlage abzulegen, zu vibrieren, zu schütteln und/oder zu wiegen ist.

9. Vereinzelungsanlage nach einem der Ansprüche 1 bis 8,
**dadurch gekennzeichnet, dass** die Entnehmereinrichtung (38) zugleich als mindestens eine Bearbeitungseinrichtung zum Bearbeiten des entnommenen Bauelements (36) gestaltet ist, insbesondere als eine Formänderungseinrichtung, eine Montageeinrichtung und/oder eine Messeinrichtung.

10. Vereinzelungsanlage nach einem der Ansprüche 1 bis 9,
**dadurch gekennzeichnet, dass** eine Bilderkennnungseinrichtung (58) zum Erkennen der Lage von mindestens einem Bauelement (36) in dem Bauelementbehälter (34) vorgesehen ist.

11. Vereinzelungsanlage nach einem der Ansprüche 1 bis 10,
**dadurch gekennzeichnet, dass** eine Manipulationseinrichtung zum Verändern der Lage von mindestens einem Bauelement (36) in dem Bauelementbehälter (34) vorgesehen ist.
